# EUROPEAN PATENT SPECIFICATION

(11) **EP 2 201 679 B1**
(45) Date of publication and mention of the grant of the patent: **20.02.2019**
(21) Application number: 08799446.3
(22) Date of filing: 11.09.2008
(51) Int. Cl.: H03F 1/14, H03F 3/60, H01P 5/107

(54) **LOW-LOSS INTERFACE**
VERLUSTARME SCHNITTSTELLE
INTERFACE À FAIBLES PERTES

(30) Priority: 11.09.2007 US 853287; 28.02.2008 US 39529; 13.03.2008 US 36417
(43) Date of publication of application: 30.06.2010
(73) Proprietor: ViaSat, Inc., Carlsbad, California 92009 (US)
(72) Inventor: COOK, Dean, Mesa Arizona 85213 (US); FILREIS, Jon, Mesa Arizona 85213 (US); LOPEZ, Noel, Phoenix Arizona 85044 (US); ZIENKEWICZ, Rob, Chandler Arizona 85248 (US); WOODS, Charles, Gilbert Arizona 85296 (US)
(74) Representative: EIP
(86) International application number: PCT/US2008/075969
(87) International publication number: WO 2009/036134

(56) References cited:
- EP-A1- 0 834 954
- EP-A1- 1 494 309
- WO-A1-02/071533
- DE-A1- 3 127 693
- DE-C1- 19 636 890
- JP-A- 2004 254 223
- JP-A- 2005 039 414
- US-A- 5 218 373
- US-A- 5 488 380
- US-A- 5 945 894
- US-A1- 2007 096 805
- US-B1- 6 363 605
- US-B2- 7 180 394
- LI J ET AL: "A NOVEL WAVEGUIDE-TO-MICROSTRIP TRANSITION FOR MILLIMETER-WAVE APPLICATIONS", INTERNATIONAL JOURNAL OF INFRARED AND MILLIMETER WAVES, SPRINGER, DORDRECHT, NL, vol. 25, no. 3, 1 March 2004 (2004-03-01), pages 513-521, XP001189855, ISSN: 0195-9271, DOI: 10.1023/B:IJIM.0000019318.75753.E2

## Description

### Field of Invention

The present invention generally relates to an interface for use, for example, between an integrated circuit and a waveguide. More particularly, the present invention relates to an interface comprising an impedance circuit such as a step launch that transports or transforms energy from an integrated circuit, such as a monolithic microwave integrated circuit, to a waveguide without the use of a dielectric material.

In another exemplary embodiment, the present invention generally relates to an interface for use, for example, between an integrated circuit and a waveguide. More particularly, the present invention relates to an impedance matching interface such as a step launch that transports or transforms energy from an integrated circuit, such as a monolithic microwave integrated circuit. In one exemplary embodiment, the impedance matching capability is adjustable.

In another exemplary embodiment, the present invention generally relates to an electrical system comprising two or more circuits. More particularly, the present invention relates to an electrical system with two or more circuits that are connected to a waveguide for power combining.

### Background of the Invention

There are numerous circuits and other electronic devices that produce energy waves, such as electromagnetic waves and microwaves. These circuits produce energy waves that are delivered to a destination through different wires, guides, and other mediums.

Transitioning microwave signals from one mode to another or interfacing to another medium is "lossy." The signal/energy is lost to radiation, metal losses, dielectric losses, and mismatch losses. By being lossy, a portion of the signal is lost as it travels through the circuits, wires, and other mediums. Stated another way, a signal entering a lossy material will be greater at the point of entry than at the point of exit.

Transitions at microwave frequencies are particularly difficult and lossy. Dielectric materials have higher loss tangents at microwave frequencies versus lower frequencies. At microwave frequencies metal losses become greater due to reduced skin depth and increased sensitivity to surface roughness. Apart from materials being lossier at microwave frequencies, the design of the transitions and interfaces is more difficult. It is difficult to control or predict phase at microwave frequencies. This leads to greater mismatch losses. Typically, the simpler an interface is, the less loss it will experience. One exemplary circuit that generates and transports microwaves is a "monolithic microwave integrated circuit" or "MMIC." Lost signal waves are unusable and decrease the efficiency of a MMIC as the signal strength decreases due to loss. Generally, the higher the frequency of the microwave, the more lossy the transmission medium and more inefficient the circuit. In certain applications, even signal losses that reduce the signal small amounts, such as 1/10 of a decibel, may result in a significant performance loss. One exemplary application where loss from energy waves such as microwaves is problematic is a power amplifier.

One structure used to reduce lossiness is a waveguide. Waveguides are structures that guide energy waves with minimal signal loss. Unfortunately, signal loss is still problematic with certain waves because the connection or interface between the circuit generating the energy waves and the waveguide can be lossy itself. This is especially an obstacle with MMIC generated microwaves. Moreover, impedance mismatches also cause signal losses. For example, the impedance of the MMIC, for example fifty ohms, may not match the impedance of the connected waveguide, which is much higher, typically several hundred ohms higher than the impendence of the MMIC. Moreover, the MMIC and waveguide also likely have different modes of energy wave propagation. These types of interfaces are known generally as "impedance matching interfaces" or "impedance matching and transforming interfaces" and these interfaces transform impedance and wave mode propagation of the energy traveling through the interface. Throughout, the term "interface" is meant to denote an "impedance matching interface" or "impedance matching and transforming interface."

Current interfaces between a MMIC and waveguide comprise numerous structures that include wirebonds, microstrips, pins, and other devices to connect a circuit to a waveguide or another structure. Each part of a matching network has associated loss. These interfaces also attempt to match and transform the impedance of the MMIC to the impedance at the waveguide. However, current impendence matching interfaces between an integrated circuit such as a MMIC and a waveguide still have an unacceptable amount of loss.

Current interfaces also use dielectrics to match impedance. While effective, interfaces that require dielectric materials are more expensive to produce and require a greater number or parts or materials as a dielectric must be included. Use of a dielectric also reduces the interface's efficiency as the dielectric also has an associated loss.

The interfaces between a waveguide and an integrated circuit tend to be lossy in part, due to the initial transition from a circuit such as a MMIC to the interface. This initial transition between an integrated circuit and an interface is lossy due to the impedance difference between the integrated circuit and interface. One way to reduce this initial loss is to closely match the impedance of the MMIC or other integrated circuit with the interface at the transition point.

MMICs also have some of the greatest and most noticeable amounts of signal loss due to the types of interfaces used to connect MMICs to other energy transmission devices, such as waveguides. Moreover, impedance mismatches from the MMIC to the waveguide enhance signal losses. For example, the impedance of the MMIC, for example fifty ohms, may not match the impedance of the connected waveguide, which is much higher, typically several hundred ohms higher than the impendence of the MMIC. Further, the MMIC and waveguide also likely have different modes of energy wave propagation.

Current interfaces between a MMIC and waveguide comprise numerous structures that include wirebond, microstrips, pins, and other devices to connect a circuit to a waveguide or another structure. Each part of a matching network has associated loss. These interfaces also attempt to match and transform the impedance of the MMIC to the impedance at the waveguide. These types of interfaces are known generally as "impedance matching interfaces" or "impedance matching and transforming interfaces" and these interfaces transform impedance and wave mode propagation of the energy traveling through the interface. Throughout, the term "interface" is meant to denote an "impedance matching interface" or "impedance matching and transforming interface." However, current impendence matching interfaces between an integrated circuit such as a MMIC and a waveguide still have an unacceptable amount of loss. Much of this loss is due to the extra components such as microstrips, suspended strip lines and pins that result in higher loss.

Besides lossiness, MMICs and other similar circuits suffer from an excess of "ripple." Ripple is unwanted gain variation versus frequency due to the mismatch of impedances at two electronic devices, such as a microstrip track and MMIC or from a microstrip to a suspended stripline or from a suspended stripline to a waveguide. When there is a mismatch, there is a return wave that generates a standing wave. This standing wave is what causes the ripple versus frequency.

Further, there are numerous circuits and other electronic devices that produce energy waves, such as electromagnetic waves and microwaves. These circuits produce energy waves that are delivered to a destination through different wires, guides, and other mediums. Certain exemplary circuits comprise integrated circuits such as a MMIC.

MMICs are used in various electrical systems to up convert, down convert, and/or amplify RF signals. In certain situations, the amount of RF power desired for a particular electrical system is greater than a single MMIC or other circuit can provide or withstand. In these situations, two or more MMIC's (or other circuits) may be used in parallel.

Electrical systems that include more than one circuit have various disadvantages. This is particularly the case when the electrical system also contains numerous other components where the impedance experienced by the energy at the MMIC must closely match the impedance the energy will experience at other components such as a waveguide to reduce energy loss. One exemplary electrical system where this is especially problematic is a system that comprises an integrated circuit such as a MMIC transitioning to a waveguide.

Electrical systems comprising two or more MMICs connected to a waveguide typically include a power combiner to combine the power from multiple MMICs before delivering it to the waveguide. Power combiners, such as a waveguide combiner tend to be complicated, heavy, and expensive and thus they are cost prohibitive. Further, power combiners increase the size of electrical systems to the point where the system itself is too big for many applications. Other known systems utilize a technique known as power splitting.

Certain systems, devices, and methods exist that combine the power produced by multiple MMICs without the use of separate power combiners. These devices include coaxial devices and cables, amplifiers such as a Grid Amplifier® produced by the Wavestream Corporation of San Dimas, California, and other spatial combining devices. While effective, these devices tend to have unacceptable amounts of energy loss and are not thermally efficient. Energy loss is particularly problematic at higher frequencies. In certain applications, even signal losses that reduce the signal small amounts, such as 1/10 of a decibel, may result in a significant performance loss. One exemplary application where loss from energy waves such as microwaves is problematic is a power amplifier.

Therefore, it would be advantageous to provide an interface between an integrated circuit, such as a MMIC, and a waveguide, or other structure that reduces signal loss. It would also be advantageous to produce an interface that reduced loss that was inexpensive and easy to manufacture, particularly one that was constructed from parts that were commercially available and did not require the use of dielectric materials or microstrips.

Therefore, it would also be desirable to provide an interface between an integrated circuit, such as a MMIC, and a waveguide, or other structure that reduces signal loss. It would also be desirable to produce an interface that reduced ripple to decrease loss. It would also be advantageous if the interface was configured to closely match the impedance of the MMIC to the interface at the transition point.

It would further be advantageous to produce an interface that reduced loss that was inexpensive and easy to manufacture, particularly one that was constructed from parts that were commercially available and did not require the use of dielectric materials or microstrips and one that directly wirebonded an integrated circuit such as a MMIC to a waveguide.

It would be also be advantageous to provide an electrical system that is compact and cost effective with two or more MMICs or other integrated circuits. It would also be advantageous to provide a system that combined the power from two or more integrated circuits that had minimal signal loss when the circuit was connected to another structure such as a waveguide. It would also be advantageous to provide a system with two or more integrated circuits that was thermally efficient. Documents EP1494309and WO02/071533 disclose transitions between MMIC's and waveguides with wave guide step launch included. Document EP0834954 relates to a transition between a planar circuit and a waveguide circuit having a step launch.

### Summary of the Invention

The invention refers to a system according to claim 1.

### Brief Description of the Drawings

A more complete understanding of the present invention may be derived by referring to the detailed description and claims when considered in connection with the Figures, where like reference numbers refer to similar elements throughout the Figures, and:
**FIG. 1** illustrates an exemplary drawing of the interface connecting a MMIC to a waveguide in accordance with an example of the present invention;
**FIG. 2** illustrates an exemplary drawing depicting the top view of the interface connecting a MMIC to a waveguide as shown in FIG. 1 in accordance with an example of the present invention;
**FIGS. 3A-3D** illustrate various cutaway views of the interface and exemplary drawing of connection mechanisms for connecting an integrated circuit such as a MMIC to the interface in accordance with an example of the present invention;
**FIG. 4** illustrates a cross sectional view of an interface connecting a MMIC to a waveguide wherein the interface is a single ridge interface comprising an isolation wall and an adjustable turning screw in accordance with an exemplary embodiment of the present invention;
**FIG. 5** illustrates a cross sectional view of an interface with a double ridge step launch in accordance with another exemplary embodiment of the present invention;
**FIG. 6** illustrates a cross sectional view of an interface connecting a MMIC to a waveguide wherein the interface has a ninety degree transference of energy in accordance with another exemplary embodiment of the present invention;
**FIG. 7** illustrates a cross sectional view of an interface in accordance with another exemplary embodiment of the present invention;
**FIG. 8** illustrates a cross sectional view of an interface with a turning screw being on the opposing side of a step launch according to another exemplary embodiment of the present invention;
**FIG. 9** illustrates a cross sectional view of an interface connected to two electronic circuits and an interface according to another exemplary embodiment of the present invention;
**FIG. 10** illustrates a side view of two interfaces located on the input and output side of a circuit according to another example of the present invention;
**FIG. 11** illustrates a cross-sectional view of an electrical system with two circuits directly connected to a waveguide cavity in accordance with one example of the present invention;
**FIG. 12** illustrates a top view of an electrical system with two circuits directly connected to a pin(s) in accordance with one example of the present invention;
**FIG. 13** illustrates a cross-sectional view of the electrical system shown in FIG. 12 in accordance with an example of the present invention;
**FIG. 14** illustrates a cross-sectional view of an electrical system with four circuits directly connected to a pin(s) in accordance with one example of the present invention;
**FIG. 15** illustrates a top view of a device used to split and combine power from four circuits comprising four circuits directly connected to a pin in accordance with one example of the present invention;
**FIG. 16** illustrates a top view of one level of a multi-level electronic system compromising two couplers and a waveguide configured to split the signals into four signals;
**FIG. 17** illustrates a top view of another level of a multi-level section electrical device also comprising two couplers and a waveguide configured to combine the energy of four signals into one signal; and
**FIGS. 18A-18C** illustrate an electronic device with a perspective view in FIG. 18A, and an exploded view in 18B.

### Detailed Description

In accordance with one aspect of the present invention, an interface for connecting an integrated circuit to an energy transmission device such as a waveguide is disclosed.

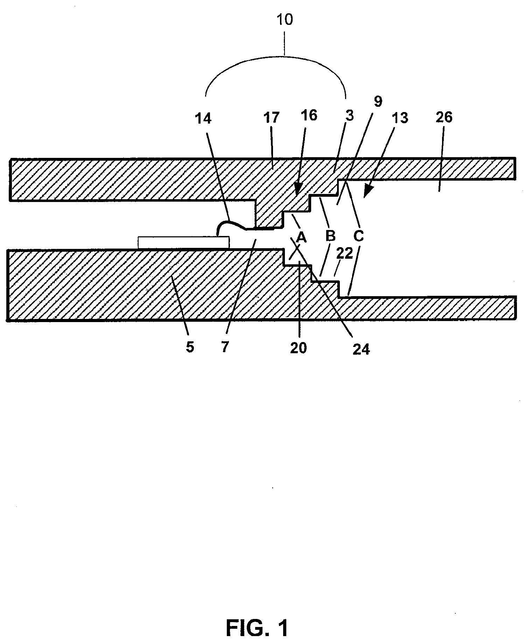

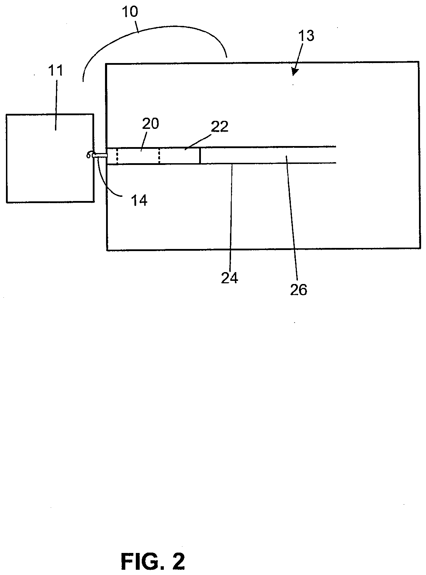

With reference to FIGS. 1, 2, and 3A-3D, and in accordance with an example of the present invention, an interface 10 is provided between an integrated circuit 11 and an energy transmission device 13. For example, interface 10 may be provided between a MMIC and a waveguide. Interface 10 is configured to be a low-loss interface and comprises a step launch 16 that directly connects circuit 11 to energy transmission device 13 without the use of dielectric materials. Interface 10 is configured to match the impedance and mode of energy wave propagation from circuit 11 to energy transmission device 13.

As shown in the example depicted in FIG. 1, interface 10 may be formed from two pieces of energy transmission material such as a lid 3 and a package base 5 being connected together. In this exemplary embodiment, lid 3 and base 5 are formed in such a shape that when these two parts are properly aligned they form a cavity that comprises step launch 16 of interface 10 and that further comprises the energy transmission device 13. In an example the two housing portions are shaped such that when brought together they form a recess that is interface 10 and waveguide 13 and where interface 10 is a gradual transition to the waveguide cavity. In other embodiments, interface 10 forms an abrupt mechanical transition from circuit 11 to the waveguide cavity or other energy transmission device 13.

Thus, in one example interface 10 comprises a stepped transition starting with a relatively smaller cavity 7 and increasing in size up to the size of the waveguide cavity. Interface 10 thus has a smaller cavity 7 at a first end and a larger cavity 9 at an opposing end. In other examples another type of transition is used that non-stepped and abrupt instead of a gradual transition.

It should be noted that the term "low-loss" refers to the ability to minimize signal loss as discussed above. In an exemplary embodiment, interface 10 connects an integrated circuit 11 to energy transmission device 13 while matching the impedance and mode of energy wave propagation of energy transmission device 13 to prevent signal loss. Further, it should be noted that while reference herein is made to interface 10 matching the impedance and mode of energy wave propagation of energy transmission device 13 on the end 9 of interface 10 contacting energy transmission device 13, interface 10 also conversely matches the impedance and mode of energy wave propagation of circuit 11 on the end 7 of interface 10 connected to circuit 11.

In another example interface 10 connects any two devices that transmit and/or produce energy. Interface 10 can be used with transmitters, receivers, or transceivers. In this regard, interface 10 can connect two circuits 11 such as two MMICs, or it can connect two energy transmission devices 13 such as two waveguides. Furthermore, interface 10 can be any device configured to transmit energy and match impedance between two or more energy producing or transmission devices.

In one example circuit 11 is a monolithic microwave integrated circuit (MMIC). In another exemplary embodiment, circuit 11 comprises discrete components on a circuit board such as power amplifiers, low noise amplifiers, detectors, limiters, isolators, switches, filters, multiplexers, couplers, and the like. Circuit 11 can be any type of circuit, circuit board, printed circuit board, integrated circuit, discrete component, combination of discrete components, or other type of device or medium that produces, receives, or transfers microwave signals. As such, the term "circuit" is not limited to devices with discrete components on a circuit board but rather includes any device that passes energy waves such as wires, cables, or waveguides. Similarly, energy transmission device 13 can be any type of device or medium configured to transport energy. In one example energy transmission device 13 is a waveguide that transports microwave energy waves. In another exemplary embodiment, energy transmission device 13 comprises wires, cables or other devices configured to transport and guide energy waves from one source to another.

In one example step launch 16 is any device that has a relatively small cavity at end 7 near circuit 11 and a relatively larger cavity at end 9 near energy transmission device 13. Moreover, step launch 16 is configured to match the impedance of circuit 11 on one end and match the impedance of energy transmission device 13 on the opposing end by gradually adjusting the impedance from end 7 to end 9.

In one example step launch 16 is a stepped transition with a series of steps such as step A, step B, and step C that result in a cavity at end 7 that is smaller than the cavity at end 9. The cavity may be square, round, oval, or any other suitable shape, and the shape may or may not change from one end to the other. Moreover, the cavity may or may not be symmetrical. In various examples step launch 16 comprises a smooth transition as opposed to a stair-step shape. For example, the transition from end 7 to end 9 may comprise a straight line, an exponential shape, and/or any other curve or function or combination of shapes.

In an example step launch 16 comprises a body 17 that defines a first ridge 20 and a second ridge 22 that form steps A and B collectively. Body 17 defines a space 24 that leads into cavity 26 defined by energy transmission device 13 such as a waveguide. In one example step launch 16 is configured such that the space between successive steps increases in the direction from end 7 to end 9. The depth and/or height of each step may be the same from step to step so that each step may resemble the step before it. In other embodiments, however, the depth and/or height of each step may vary compared to one or more other steps in the step launch.

Step launch 16 can be constructed from any conductive material that minimizes loss. In an exemplary embodiment, step launch 16 is gold plated. In other exemplary embodiments, step launch 16 is comprised of silver, copper, aluminum, plated plastics, plated ceramics, various metals and/or alloys, and/or other similar materials with low resistance. Any materials configured to facilitate impedance matching and reduce signal loss can be used to construct step launch 16.

In example the step launch 16 comprises a single ridge step launch (e.g., steps A and B of the top side only). The step launch is configured to provide a stepped transition from the impedance of circuit 11 to the impedance of waveguide 13. In other examples step launch 16 comprises a double ridge step launch (e.g., steps A, B, and C with a top and bottom) to accommodate waveguide cavities or other similar energy transmission devices with various sizes and impedance requirements. The number of ridge steps is typically related to the size of cavity 26 in that the larger cavity 26, the greater number of ridge steps may be used to match the output impedance of circuit 11 to cavity 26.

The number of ridges is a function of room available for transition and manufacturability of steps. Specifically, a smaller cavity may have less step features than a larger cavity. According to an example of the present invention, any number of ridges, steps, or other similar features can be used and fall within the scope of the present invention. In yet other examples step launch 16 can comprise a smooth, slopped transition without steps. The angle of the transition can be whatever angle needed to accommodate energy transmission device 13. Certain exemplary stepped transitions for various step launches 16 include, but are not limited to, triangular, exponential, or Klopfenstein tapers.

In accordance with an example interface 10 further comprises a pin 14 connected to a step launch 16. Pin 14 is generally a compressible, tension absorbing interface pin such as a spring configured to transmit energy. In an exemplary embodiment, pin 14 can be any shape and have any number of sides, including, but certainly not limited to, round, ovular, hexagonal, polygonal, square, rectangular, and triangular. Pin 14 may comprise an electrically conductive low-loss compressible material. Pin 14 may be formed from conductive material(s) which minimize energy loss. Certain exemplary materials include, but are not limited to, gold, silver, copper, various alloys, beryllium, copper, tungsten, and/or other similar materials with high conductivity and low resistance.

In an example pin 14 is formed from a single piece of conductive material. However, in other exemplary embodiments, pin 14 is formed from numerous pieces of conductive material that are joined together. The pieces of conductive material can be joined by soldering, welding, spot welding, brazed, epoxied, or mechanical connection points. The pieces of conductive material can be stacked if pin 14 is rectangular or square shaped or shaped in hemispheres if pin 14 is circular or oval. Moreover, individual strands of circular material can be used to form pin 14. Furthermore, any device or piece of material configured to transport energy can be used as pin 14.

In an example pin 14 is also configured to be compressible and flexible. This enables interface 10 to be used in applications that will result in movement of interface 10 through vibration, thermal expansion, or other causes. In that regard, pin 14 is capable of being compressed inward towards circuit 11 and stretched outward away from circuit 11 to allow interface 10 relative movement during use and not become disconnected from circuit 11 or energy transmission device 13.

Certain exemplary pins are 0.15 millimeters to fifty millimeters in length. Pin 14 can be any size suitable for the particular location that interface 10 is used for. For example, if a long distance is required between circuit 11 and the energy transmission device 13, pin 14 can be longer to accommodate that distance. Further, in certain other examples pin 14 can be a probe, a coaxial pin, cable or another type of device with a coaxial configuration.

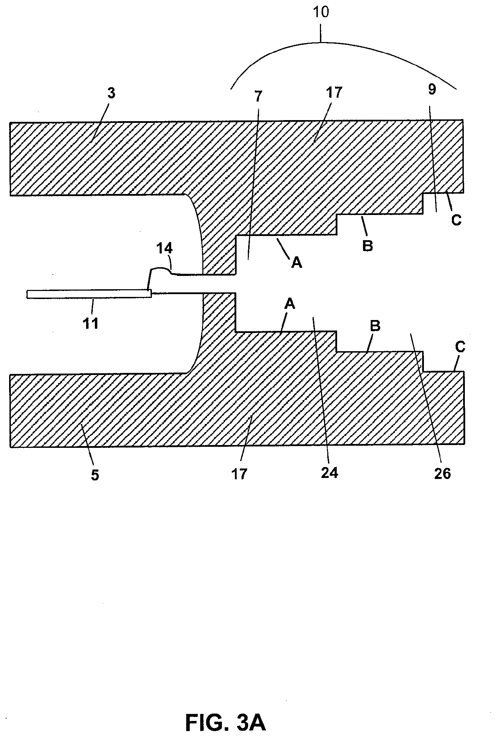

With reference to FIGS. 1 and 3A, and in accordance with an example of the present invention, one end of pin 14 is attached to step launch 16. Furthermore, pin 14 may be attached to the step launch 16 on the underside of step launch 16, i.e. to lid 3. In another exemplary embodiment, the opposing end of pin 14 is configured to extend out over circuit 11 and contacts circuit 11 at a point of connection (such as a bond pad, an output pad or other similar device). In an example step launch 16 is a waveguide step launch and is sized to fit within or correspond to energy transmission device 13 such as a waveguide.

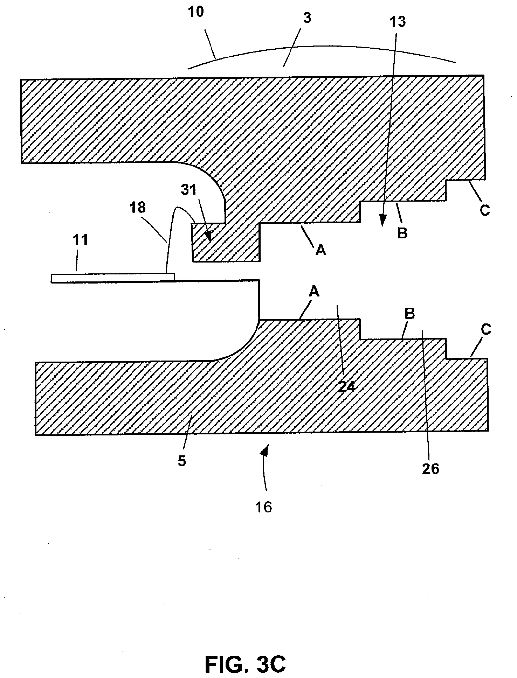

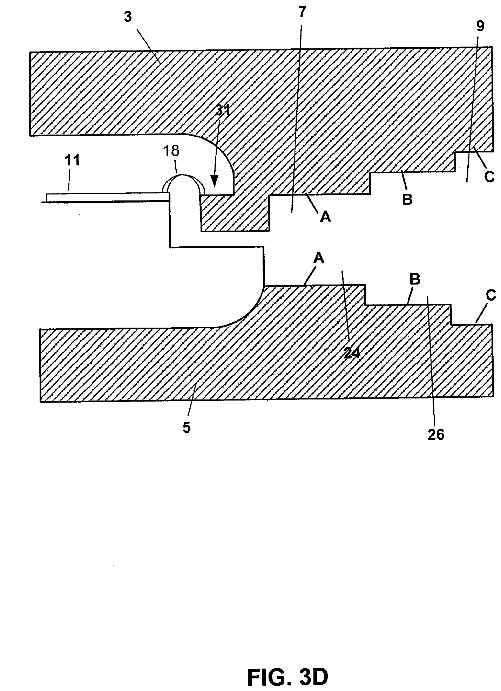

In an example and with reference now to FIGS. 3C and 3D, step launch 16 is connected to circuit 11 by connection member 18. Connection member 18 can be any type of device that allows energy to pass from step launch 16 to circuit 11. Connection member 18 is flexible and has a certain mechanical give in one exemplary embodiment. In other exemplary embodiments, connection member 18 is rigid or semirigid.

With reference to FIGS. 3A-3D and according to examples of the present invention, various different forms of connection members can be used in the present invention. Exemplary connection members have the same impedance as circuit 11 and are configured to have the same mode of energy wave propagation. In one example connection member 18 is a wirebond(s) or ribbon bond. In another example the connection member is a spongy material 30 that is conductive in the z-axis (the z-axis is perpendicular to MMIC bond pads).

There are numerous ways and various connection points to connect circuit 11 to interface 10. Certain exemplary connections of interface 10 to circuit 11 are shown in FIGS. 3A-3D. With reference to FIG. 3A, in one example the pin 14 is attached to the underside of step launch 16 on one end and contacts circuit 11 on the other end.

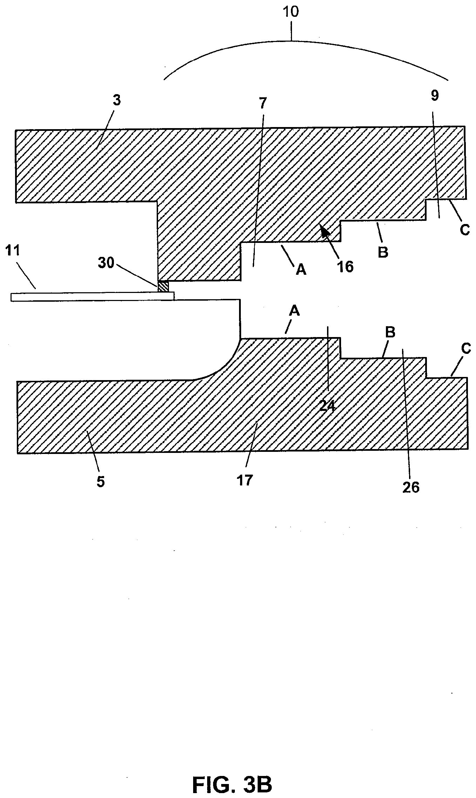

In another example and with reference to FIG. 3B, spongy material 30 is connected to the underside of step launch 16 on one end and to circuit 11 on the other end of the spongy material. In another example and with reference to FIG. 3C, lid 3 may comprise a ledge 31 that sticks out from the lid material and provides a surface for connecting a wire bond 18 to the top of the stub. In this exemplary embodiment stub 31 extends outward from step launch 16 on one end and is connected to circuit 11 via connection member 18.

With reference to FIG. 3D, in yet another example interface 10 can be offset from circuit 11. In this example the top of stub 31 is in coplanar orientation with respect to circuit 11 and wirebond 18 connects stub 31 to circuit 11. Coplanarity may help reduce loss at microwaves frequencies.

In various examples interface 10 serves as a pathway for various energy waves, such as RF waves and microwaves. Interface 10 provides impedance and mode transformation to meet the desired impedances and modes of circuit 11 and energy transmission device 13. As energy is passed through interface 10 and into step launch 16, the impedance and mode of wave propagation the energy experiences at step launch 16 changes with first ridge 20 and second ridge 22 (and possibly additional ridges) to eventually match the impedance and mode of energy wave propagation of energy would experience at transmission device 13 on the opposing end of interface 10. Although depicted and described herein as vertical change in the size of the opening, this disclosure also contemplates changing the size of the opening in the horizontal direction. Thus, the size of the cavity in step launch 16 may change from end 7 to end 9 by increasing the height, width, diameter, and/or making any other suitable change to the size of the cavity.

In one example, a MMIC produces microwave energy that experiences a certain first impedance of fifty ohms. This energy experiencing a fifty ohm impedance is produced at the MMIC and is passed into interface 10 through pin 14 and then enters step launch 16. At this point, step launch 16 is configured to handle energy experiencing a fifty ohm impedance with minimal loss. As the microwave energy is traveling through step launch 16, the impedance of step launch 16 gradually changes until it is equal to the impedance of the energy transmission device 13. Therefore, the impedance the energy experiences as it travels through step launch 16 gradually changes until the impedance the energy experiences is equal to that it will experience in energy transmission device 13. As used herein, gradually means changing less abruptly than a direct change from the MMIC impedance to the waveguide impedance in one place.

In this example described, the second impedance is three-hundred and seventy seven ohms. The impedance is changed gradually on interface 10 depending on the number of transition steps or ridges defined by step launch 16 until it reaches three-hundred and seventy seven ohms, the impedance of the energy transmission device 13. Specifically, the impedance may slightly change with each step, A, B, and C as it travels through step launch 16. For example, the impedance might start out at fifty Ohms at step A, change to one hundred and fifty ohms at step B, and finally to three-hundred and seventy seven ohms at step C. Alternatively, the impedance is changed by the slope of step launch 16. Gradually changing the impedance the energy experiences minimizes loss as the energy travels through interface 10.

Besides changing the impedance, the mode of energy wave propagation is also changed as the energy travels through interface 10. For example, a mode of wave propagation for energy transmission device 13 such as a waveguide may be TE₁₀ (Transverse Electric, 10) while circuit 11 such as a MMIC may have a microstrip mode of wave propagation of quasi-TEM (Traverse Electromagnetic). Interface 10 will change the mode of wave propagation from circuit 11 to energy transmission device 13 in the same manner it changes the impedance.

Further, interface 10 is capable of matching the impedance of energy transmission device 13 with little or no signal loss. Interface 10 does not require the use of dielectric materials and/or microstrips in one exemplary embodiment. In other exemplary embodiments, some dielectric materials may be used in the manufacture of various components of interface 10.

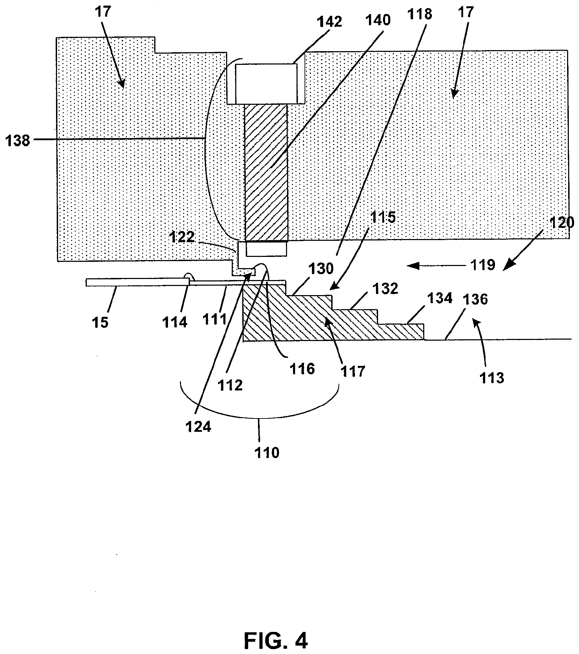

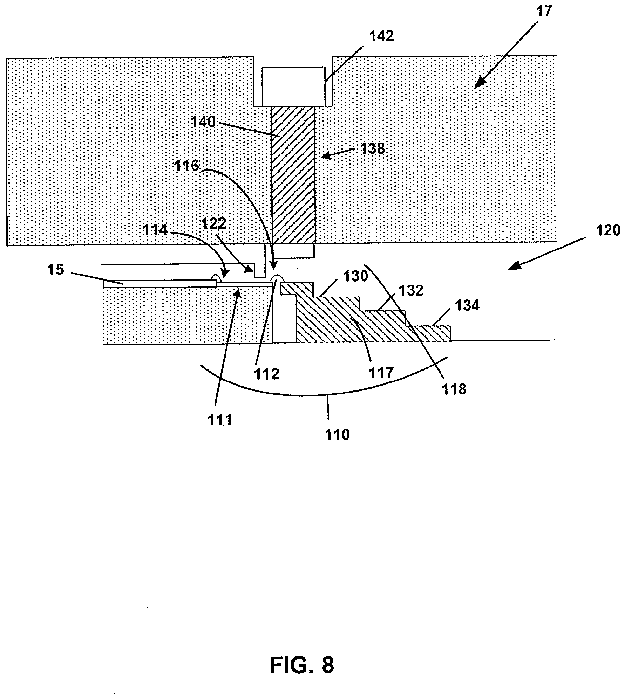

With reference to FIGS. 4-10, and in accordance with an exemplary embodiment of the present invention, an interface 110 is provided between an integrated circuit 111 and an energy transmission device 113. Certain exemplary interfaces 110 that may be used with the present invention are disclosed in co-pending and commonly owned U.S. Patent Application Serial No. 11/853,287 entitled "Low-Loss Interface" which is incorporated in its entirety by reference.

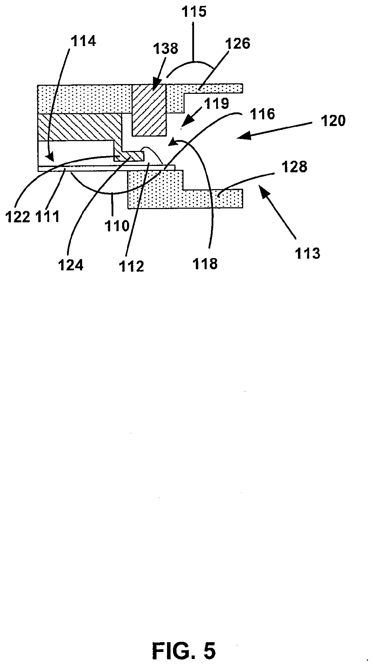

Interface 110 connects integrated circuit 111, such as a MMIC, to another energy transmission device 113 such as a waveguide. While the terms integrated circuit 111 and energy transmission device 113 are used herein, it should be understood that interface 110 can connect any energy transmission, reception, or similar device and fall within the scope of the present invention. With particular reference to FIGS. 4 and 5, interface 110, integrated circuit 111, and energy transmission device 113 are typically located within another structure 17 that surrounds various components that comprise the system that interface 110, integrated circuit 111, and energy transmission device 113 are part of. Structure 17 can comprise a lid and base as discussed below or structure 17 can be a single unit with space for integrated circuit 111, interface 110 and energy transmission device 113. In certain exemplary embodiments, structure 17 is constructed from a metal such as aluminum or copper. In other exemplary embodiments, structure 17 is plated with another metal such as gold or silver.

In one exemplary embodiment, integrated circuit 111 is a monolithic microwave integrated circuit (MMIC). Integrated circuit 111 is part of an electronic system and is connected to another electronic device such as a microstrip 15 (or any other electronic device) at an input region 114 and further connected to energy transmission device 113 at an output region 116. Input region 114 and output region 116 can be any know device that is capable of forming an electronic connection such as a wirebond. Further, various known connection mechanisms such as ribbon bonds can be used to connect input region 114 and output region 116 to other devices as explained herein.

In another exemplary embodiment, integrated circuit 111 comprises discrete components on a circuit board such as power amplifiers, low noise amplifiers, detectors, limiters, isolators, switches, filters, multiplexers, couplers, and the like. Integrated circuit 111 can be any type of circuit, circuit board, printed circuit board, integrated circuit, discrete component, combination of discrete components, or other type of device or medium that produces, receives, or transfers electronic waves such as microwave signals. As such, the terms "circuit" or "integrated circuit" are not limited to devices with discrete components on a circuit board, but rather includes any device that passes energy waves such as wires, cables, or waveguides.

Similarly, energy transmission device 113 can be any type of device or medium configured to transport energy. In one exemplary embodiment, energy transmission device 113 is a waveguide that transports microwave energy waves. In another exemplary embodiment, energy transmission device 113 comprises wires, cables or other devices configured to transport and guide energy waves from one source to another. Yet other exemplary energy transmission device 113 comprises other integrated circuits such as a MMIC or anything else that transport electrical energy.

With reference again to the exemplary embodiment depicted in FIG. 4, interface 110 comprises a stepped transition defining an interface cavity 118 that increases in size up to the size of a waveguide cavity 120. The stepped transition may comprise a step launch 115 defining a body 117 which in turn defines a series of ridges or steps 130, 132, 134, and 136 disposed between interface cavity 118 and waveguide cavity 120. Body 117 further defines a space 119 that leads into waveguide cavity 120. In one exemplary embodiment, step launch 115 is configured such that space 119 between successive steps 130, 132, 134, etc. increases in the direction from interface cavity 118 to waveguide cavity 120. The depth and/or height of each step may be the same from step to step so that each step may resemble the step before it. In one exemplary embodiment, the height of each step is 0.5 mm at Ka band frequencies. At lower frequencies, the height can more significant; an exemplary height is 3 mm. In other embodiments, however, the depth and/or height of each step may vary compared to one or more other steps in the step launch. Steps are not limited to being monotonic. Moreover, the corner or edges of steps 130, 132, 134, and 136 are rounded to the range of 0.001 mm to 1 mm in one exemplary embodiment which further reduces loss.

Step launch 115 can be constructed from any conductive material that minimizes loss. In an exemplary embodiment, step launch 115 is gold plated. In other exemplary embodiments, step launch 115 is comprised of silver, copper, aluminum, plated plastics, plated ceramics, various metals and/or alloys, and/or other similar materials with low resistance. Any materials configured to facilitate impedance matching and reduce signal loss can be used to construct step launch 115.

In one exemplary embodiment depicted in FIGS. 4, 6, 7, and 8, step launch 115 comprises a single ridge step launch (e.g., steps 130, 132, 134, etc. on one side only). Step launch 115 is configured to provide a stepped transition from the impedance of integrated circuit 111 to the impedance of energy transmission device 113. In another exemplary embodiment depicted in FIG. 5, interface 110 comprises double ridge device (e.g. steps 130, 132, 134 etc. on two sides) and may be formed from two pieces of energy transmission material such as a lid 126 and a package base 128 connected together. In this exemplary embodiment, lid 126 and base 128 are formed in such a shape that when these two parts are properly aligned they form space 119 that comprises step launch 115 of interface 110 and that further comprises energy transmission device 113. In an exemplary embodiment, the two housing portions are shaped such that when they are brought together they form a recess that is interface 110 and energy transmission device 113 and where interface 110 is a gradual transition to waveguide cavity 120. Interface 110 can be located on lid 126 or on the base 128 as shown. When interface 110 is disposed on lid 126, insertion loss may be less than 0.2 dB when energy frequency is increased from 15 GHz to 38.6 GHz. In various other exemplary embodiments, interface 110 forms an abrupt mechanical transition from integrated circuit 111 to the waveguide cavity or other energy transmission device 113.

In this exemplary embodiment depicted in FIG. 5, step launch 115 comprises a double ridge step launch to accommodate waveguide cavities or other similar energy transmission devices with various sizes and impedance requirements. The number and size of steps is typically related to the frequency. The lower the frequency the larger the size of waveguide cavity 120 in that the larger waveguide, the greater number of steps may be used to match the output impedance of integrated circuit 111 to waveguide cavity 120. Having more steps will reduce minimize return loss and RF discontinuities in the transition. It should also be noted that the steps' length and height can be selected to reduce loss depending on the application that interface 110 is used for. For example, the second ridge or step of the step launch can be built to be longer than the first ridge as shown. In this embodiment, the insertion loss has been shown to be less than 0.2 dB from 27 GHz to 38.6 GHz. In other embodiments, adjusting the various dimensions of the ridges or steps has reduced insertion loss to less than 0.1 dB based on an energy frequency increase from 27 GHz to 38.4 GHz.

The number of steps may be a function of room available for transition and manufacturability of steps. Specifically, a smaller cavity may have less step features than a larger cavity. According to an exemplary embodiment of the present invention, any number of ridges, steps, or other similar features can be used and fall within the scope of the present invention. In yet other exemplary embodiments, step launch 115 can comprise a smooth, slopped transition without steps. The angle of the transition can be whatever angle needed to accommodate energy transmission device 113. Certain exemplary stepped transitions for various step launches 115 include, but are not limited to, triangular, exponential, or Klopfenstein tapers.

Interface 110 may comprise an isolation wall 122 that is located between input region 114 and output region 116. Isolation wall 122 is any structure that separates input region 114 from output region 116 and is configured to reduce ripple and other interference between input region 114 and output region 116 to reduce loss. Certain exemplary isolation walls 122 comprise metal structures, microwave absorbers, and dielectrics. Reducing the ripple at this location also reduces the overall loss of energy waves at the transition between integrated circuit 111 and energy transmission device 113.

Further, isolation wall 122 isolates the input and output pads (i.e. the input region 114 and output region 116) present on integrated circuit 111 such as a MMIC. Isolating the input region 114 and output region 116 of a MMIC reduces unwanted feedback. This makes for a more stable MMIC or other integrated circuit 111 that will not oscillate.

Maintaining this isolation is important because numerous problems arise when the proper isolation is not present. For example, the oscillation experienced by certain circuits such as a MMIC is problematic as mentioned above. Further, the interactions between the input region 114 and output region 116 leads to excess ripple which in turn reduces performance, leads to less output power, and causes more gain variation. These problems are all magnified with energy at higher frequencies. Therefore, isolation wall 122 prevents loss at high frequencies and increases performance.

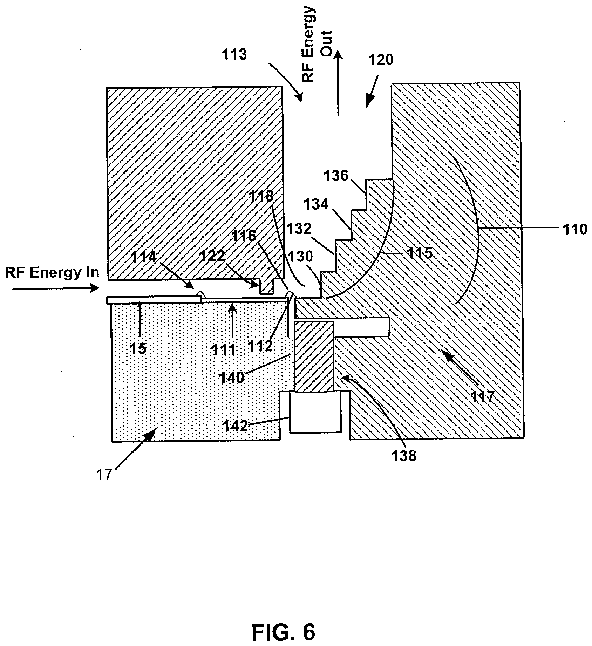

Isolation wall 122 can be constructed from the same material as structure 17 such as aluminum or copper or it can be constructed of another material and plated with silver or gold. In this exemplary embodiment, isolation wall 122 is approximately ten millimeters thick. In other exemplary embodiments, isolation wall 122 is approximately ten to fifty millimeters thick. Any size or shape of isolation wall 122 that is configured to reduce ripple by isolating input region 114 from output region 116 falls within the scope of the present invention. Further, isolation wall 122 can be a simple a vertical member as depicted, for example, in FIGS. 6, 7, and 8 or it can have a flange 124 or other similar horizontal member as depicted in FIGS. 4 and 5.

In certain exemplary embodiments, isolation wall 122 is placed at a distance of approximately .5 to .05 millimeters above integrated circuit 111. In other exemplary embodiments, isolation wall 122 is placed at a distance in the range of .25 millimeters above integrated circuit 111 or anywhere in a range of approximately .25 to .5 millimeters above integrated circuit 111. In yet other exemplary embodiments, other height ranges can be used and fall within the scope of the present invention. Further, in an exemplary embodiment when a MMIC is used as integrated circuit 111, the isolation wall is placed immediately after the last gain stage on the MMIC and before the output wirebond. However, isolation wall 122 can be placed at any location along interface 110 and fall within the scope of the present invention.

In accordance with an exemplary embodiment, interface 110 further comprises a wirebond 112 directly connecting step launch w15 to integrated circuit 111. In an exemplary embodiment, wirebond 112 can be any shape and consist of any number of wirebond. Wirebond 112 may comprise an electrically conductive low-loss material and wirebond 112 can comprise leads, pins, ribbons or anything else that connects two or more devices that transmit energy. Certain exemplary materials include, but are not limited to, gold, silver, copper, various alloys, beryllium, copper, tungsten, and/or other similar materials with high conductivity and low resistance.

Furthermore, any device or piece of material configured to transport energy can be used as wirebond 112. Certain exemplary wirebond are 0.15 millimeters to 25 millimeters in length. Wirebond 112 can be any size suitable for the particular location that interface 110 is used for. For example, if a long distance is required between integrated circuit 111 and step launch 115, wirebond 112 can be longer to accommodate that distance. Further, in certain other exemplary embodiments, wirebond 112 can be a probe, a coaxial pin, cable or another type of device with a coaxial configuration. In other exemplary embodiments, wirebond 112 is a spongy material such as disclosed in the co-pending patent application noted above entitled "Low-Loss Interface" wherein such application was previously incorporated in its entirety by reference.

Further, wirebond 112 can be connected to interface 110 at various locations. For example, as depicted in the exemplary embodiment of FIGS. 4 and 5, wirebond 112 is connected directly from the integrated circuit 111 output region 116 to isolation wall 122 via flange 124. However, in the exemplary embodiment depicted in FIGS. 6, 7, and 8, wirebond 112 is directly connected to integrated circuit 111 and to step launch 115 as shown in one exemplary embodiment in FIG. 6.

It should also be noted that more than one isolation wall 122 can be used in conjunction with interface 110 and fall within the scope of the present invention. For example, two, three or more isolation walls 122 can be used and placed in various positions at various heights above integrated circuit 111 or other components. Numerous isolation walls can also be constructed of different materials, have different sizes, or they can be constructed of the same material and have the same size.

In certain exemplary embodiments, interface 110 further comprises turning screw 138. Turning screw 138 is any adjustable member configured to adjust the size or volume of interface cavity 118 to minimize loss by closely matching the impedance of integrated circuit 111 with interface 110 at the connection between interface 110 and integrated circuit 111. The impedance is matched by adjusting the volume of interface cavity 118 to provide an interface cavity 118 with the correct dimensions to reduce the most loss. In certain exemplary embodiments, turning screw 138 is constructed from stainless steel, brass, or nylon. The screw can be constructed from electrically conductive or non-conductive material. The tip of turning screw 138 that is disposed within interface cavity can be constructed from the same or similar material as the remainder of turning screw 138. For example, the shaft of turning screw 138 could be constructed from nylon while the tip is constructed of stainless steel.

Although a specific reference is made herein to a screw functioning as turning screw 138, any other device that adjusts interface cavity 118 (or waveguide cavity 120) falls within the scope of the present invention. Other exemplary devices include adjustable pins, bolts, or other similar cylindrical structures. A rack and pinion device could also be used instead of turning screw 138 in another exemplary embodiment of the invention. Further, instead of using just a single turning screw 138, multiple turning screws or other similar devices as described herein can be used. In this exemplary embodiment, screws are placed directly over two or more of steps 130, 132, 134, and 136 to adjust the spaces in interface cavity 118 and space 119 above steps 130, 132, 134, and 136.

In yet other embodiments, turning screw 138 can be omitted and the size of interface cavity 118 can be adjusted by moving structure 17 or by moving lid 126 or package base 128. In yet other exemplary embodiments, turning screw 138 and other similar devices can be omitted entirely and interface cavity 118 can have a constant non-adjustable size.

In certain exemplary embodiments, turning screw 138 comprises a shaft 140 connected to a head 142. Turning screw 138 is adjustable and adjusts the size of interface cavity 118 to create a size that enables interface 110 to have the least amount of loss depending on the particular application that interface 110 is used for. Essentially, turning screw 138 enables the user to tune the impedance matching between interface 110 and integrated circuit 111 at the connection point. In particular, turning screw 138 may be adjusted until the interface cavity 118 is such that the least amount of loss occurs. Loss is reduced because interface cavity 118 near output region 116 is adjusted to allow the impedance of integrated circuit 111 to most closely match the impedance of cavity 113 at the location of interface cavity 118. For example, when the size of interface cavity 118 is ten millimeters the impedance of interface 110 at step launch 115 may be sixty ohms while the impedance of integrated circuit 111 is fifty ohms. However, if the size of interface cavity 118 is adjusted to eight millimeters, the impedance of interface 110 at step launch 115 may be matched exactly to be fifty ohms. Adjusting turning screw 138 allows for this precise impedance matching to occur.

Therefore, turning screw 138 enables interface 110 to be customized to reduce loss depending on the specific location in which it is used. In certain exemplary embodiments, turning screw 138 can be removed and the space occupied by turning screw 138 can be filled with another material.

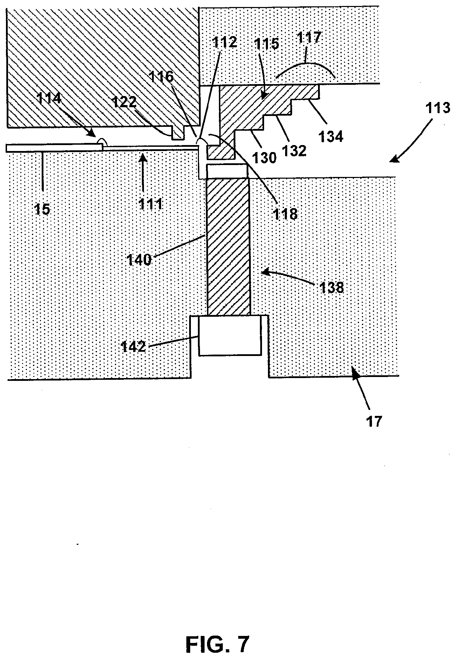

As depicted in the figures, turning screw 138 can be connected to interface 110 or oriented in numerous different ways to adjust interface cavity 118. As shown in FIGS. 4, 5, and 8, turning screw 138 is seated within body 17 or lid 126 respectively in order to place shaft 140 directly above output region 116 on the opposing side of interface 110. In other exemplary embodiments depicted in FIGS. 6 and 7, turning screw 138 is oriented in such a manner as to tune from the bottom of the waveguide cavity. Turning screw 138 can be located anywhere on interface 110 and fall within the scope of the present invention.

In various exemplary embodiments, interface 110 serves as a pathway for various energy waves, such as RF waves and microwaves. Interface 110 provides impedance and mode transformation to meet the desired impedances and modes of integrated circuit 111 and energy transmission device 113. As energy is passed through interface 110 and into step launch 115, the impedance of step launch 115 changes with first step 130 and second step 132 (and possibly additional steps 134, 136) to eventually match the impedance and mode of energy wave propagation of energy transmission device 113 on the opposing end of interface 110. Although depicted and described herein as vertical change in the size of the opening, this disclosure also contemplates changing the size of the opening in the horizontal direction. Thus, the size of the cavity in step launch 115 may change from end to end by increasing the height, width, diameter, and/or making any other suitable change to the size or volume of the cavity.

In one example, a MMIC produces microwave energy that experiences a certain first impedance of fifty ohms. In certain exemplary embodiments, the impedance of interface 110 has been adjusted to be fifty ohms by changing the size of interface cavity 118 using turning screw 138. The energy produced by the MMIC is produced at output region 116 with less ripple than normal MMIC's due to the placement of isolation wall 122 between input region 114 and output region 116. This energy experiencing a fifty ohm impedance is passed into interface 110 through wirebond 112 and then enters step launch 115. Further, the energy and associated energy waves produced by the MMIC is able to easily transition from the MMIC to interface 110 due to turning screw 138 being set to allow interface cavity 118 to have the size or volume to reduce loss the most.

At this point, step launch 115 is configured to handle energy experiencing, for example a fifty ohm impedance with minimal loss. As the microwave energy is traveling through step launch 115, the impedance of step launch 115 gradually changes until it is equal to the impedance of the energy transmission device 113. Therefore, the impedance the energy experiences as it travels through step launch 115 gradually changes until the impedance the energy experiences is equal to that it will experience in energy transmission device 113. As used herein, gradually means changing less abruptly than a direct change from the MMIC impedance to the waveguide impedance in one place.

In this example described, the energy transmission device 113 may have a second impedance of three-hundred and seventy ohms and interface 110 must match the fifty ohm impedance of integrated circuit 111 to the much larger impedance of energy transmission device 113 with minimal loss. The impedance is changed gradually on interface 110 depending on the number of transition steps or ridges defined by step launch 115 until it reaches three-hundred and seventy seven ohms, the impedance of the energy transmission device 115. Specifically, the impedance may slightly change with each step, 130, 132, and 134 as it travels through step launch 115. For example, the impedance might start out at fifty ohms at step 130, change to one hundred and fifty ohms at step 132, and finally to three-hundred and seventy seven ohms at step 134. Alternatively, the impedance is changed by the slope of step launch 115. Gradually changing the impedance the energy experiences minimizes loss as the energy travels through interface 110.

Besides changing the impedance, the mode of energy wave propagation is also changed as the energy travels through interface 110. For example, a mode of wave propagation for energy transmission device 113 such as a waveguide may be TE₁₀ (Transverse Electric, 10) while integrated circuit 111 such as a MMIC may have a microstrip mode of wave propagation of quasi-TEM (Traverse Electromagnetic). Interface 110 is configured to change the mode of wave propagation from integrated circuit 111 to energy transmission device 113 in the same manner it changes the impedance.

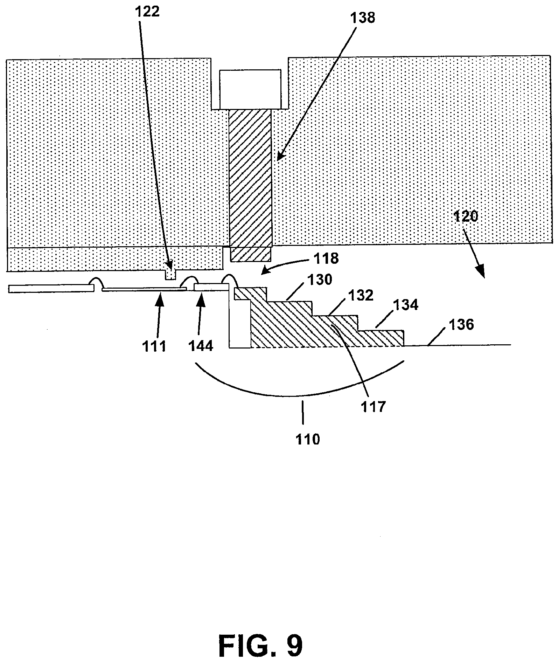

With reference now to FIG. 9 and in accordance with another exemplary embodiment of the present invention, interface 110 can be used in connection with an electrical system that comprises more than one circuit such as integrated circuit 111. Specifically, interface 110 can be part of an electrical system that comprises two circuits such as integrated circuit 111 and a secondary circuit 144. In this exemplary embodiment, the circuits are arranged serially, however, in other embodiments, other arrangements of circuits are contemplated. Certain exemplary secondary circuits comprise a microwave circuit or network. As depicted in this exemplary embodiment, isolation wall 122 is placed over integrated circuit 111. However, isolation wall 122 could be placed anywhere as noted above and more than one isolation wall 122 can be used and fall within the scope of the present invention.

Further, secondary circuit 144 may can be any circuit or other electronic device such as a MMIC or it may comprise discrete components on a circuit board such as power amplifiers, low noise amplifiers, detectors, limiters, isolators, switches, filters, multiplexers, couplers, and the like. Secondary circuit 133 can be any type of circuit, circuit board, printed circuit board, integrated circuit, discrete component, combination of discrete components, or other type of device or medium that produces, receives, or transfers electronic waves such as microwave signals. As noted before, the terms "circuit" or "integrated circuit" are not limited to devices with discrete components on a circuit board, but rather include any device that passes energy waves such as wires, cables, or waveguides.

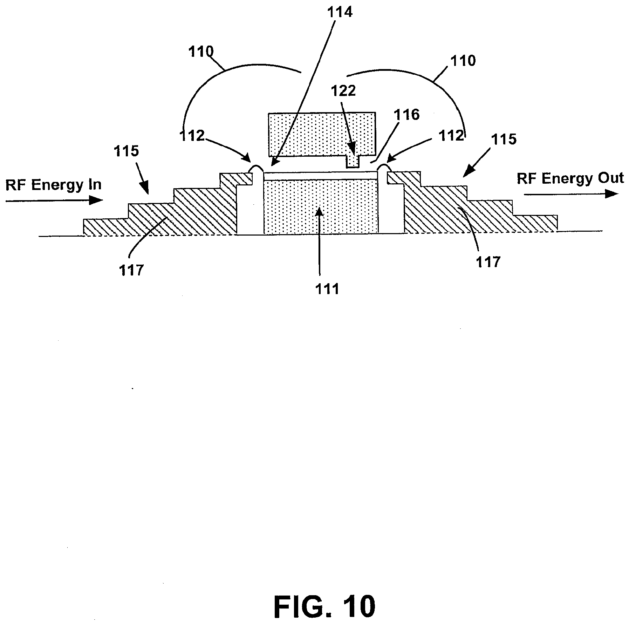

With reference now to FIG. 10 and in accordance with another exemplary embodiment of the present invention, more than one interface 110 can be used with an electrical system. As depicted, interface 110 can be on both the input and output sides (relative to the direction of energy flow, such as RF energy) of integrated circuit 111 or a plurality of circuits such as a secondary circuit 144 discussed above. Both interface 110's located on input region 114 and output region 116 of integrated circuit 111 comprise step launches 115 with a number of steps, however any step launch 115 or other similar device can be used and fall within the scope of the present invention.

Further, in accordance with another exemplary embodiment, isolation wall 122 is placed at either the input or output side of integrated circuit 111 or two isolation walls 122 can be used on both sides. Alternatively, a single isolation wall 122 can be used and placed above the middle of integrated circuit 111. As shown in this exemplary embodiment, a direct wirebond 112 interface is used to connect both the input and output regions of integrated circuit 111 to step launches 115.

As discussed above, interface 110 is capable of matching the impedance of energy transmission device 113 with little or no signal loss. Interface 110 does not require the use of dielectric materials and/or microstrips in one exemplary embodiment. In other exemplary embodiments, some dielectric materials may be used in the manufacture of various components of interface 110.

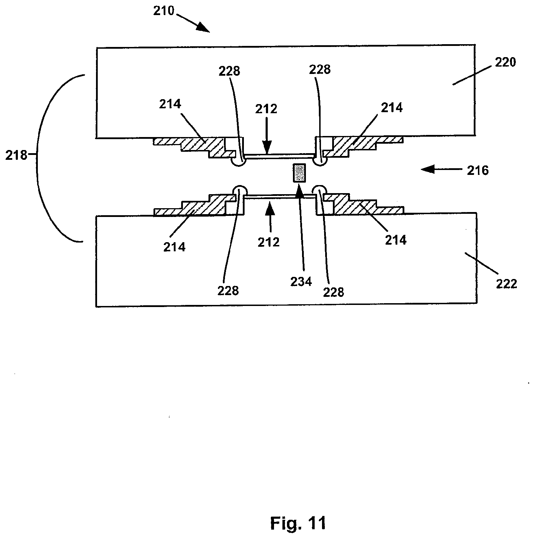

With reference now to FIGS. 11-17 and in accordance with another example system 210 comprises two or more circuits 212, an interface 214, and an energy transmission device 216. It should be noted that circuits 212, interface 214, and energy transmission device 216 can be those described in co-pending patent application serial number: 12/039,529 filed on February 28, 2008 and entitled "Adjustable Low Loss Interface" or co-pending patent application serial number 11/853,287 filed on September 11, 2007 entitled "Low-Loss Interface."

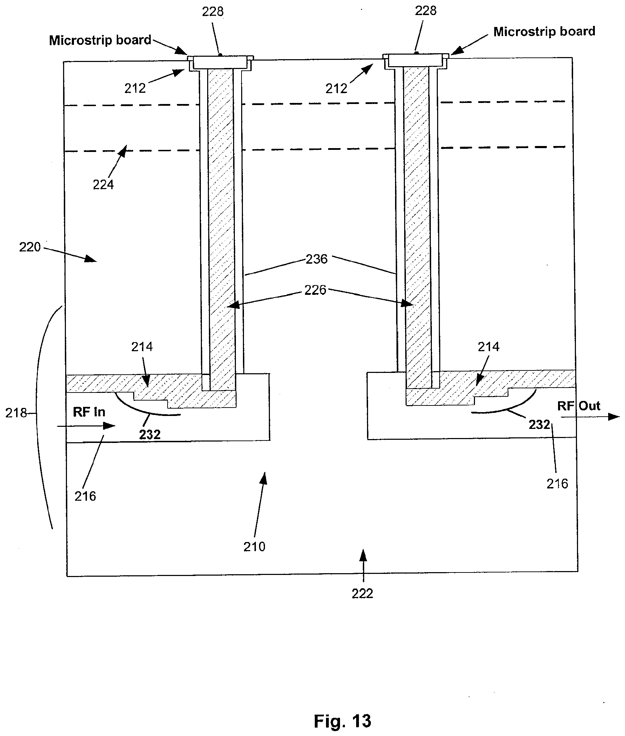

With particular reference to FIGS. 11 and 13, interface 214, circuits 212, and energy transmission device 216 are typically located within another structure 218 that surrounds the various components that comprise system 210. Structure 218 may comprise a lid 220 and a base 222 or structure 218 can be a single unit with space for circuits 212, interface 214, and energy transmission device 216. In certain examples structure 218 is constructed from metal such as aluminum or copper. In other examples structure 218 is plated with another metal such as gold or silver.

In one example circuits 212 are integrated circuits such as MMICs. In another example circuits 212 comprise discrete components on a circuit board such as power amplifiers, low noise amplifiers, detectors, limiters, isolators, switches, filters, multiplexers, couplers, and the like. Circuits 212 can be any type of circuit, circuit board, printed circuit board, integrated circuit, discrete component, combination of discrete components, or other type of device or medium that produces, receives, or transfers electronic waves such as microwave signals. As such, the terms "circuit" or "integrated circuit" are not limited to devices with discrete components on a circuit board, but rather include any device that passes energy waves such as antennas, wires, cables, or waveguides.

Circuits 212 can be attached directly to structure 218 which assists in improving heat transfer from circuits 212. In one example heat transfer from circuits 212 is improved because structure 218 is constructed of metal which conducts heat produced by circuits 212 away from system 210. Further, structure 218 may further comprise one or more heat pipes 224 which assist in efficiently moving large amounts of heat produced by circuits 212. In other examples heat pipes 224 are not utilized.

In one example circuit 212 is not disposed within a waveguide cavity. Therefore, circuit 212 is not constrained by the physical size or dimensions of the waveguide cavity. Thus, a larger, more powerful circuit 212 may be used.

In one example heat pipes 224 are disposed within structure 218 adjacent to circuits 212 and comprise metal straws or other similar structures filled with phase change fluid. Certain exemplary heat pipes 224 are approximately two to three millimeters in thickness. In other examples heat pipes 224 are hollowed out portions of structure 218. Besides phase change fluid, other fluids such as air, water, coolants, or other similar fluids can be used with heat pipes 224. In fact, any device disposed within or comprised of structure 218 that is configured to conduct heat away from circuits 212 can function as heat pipes 224.

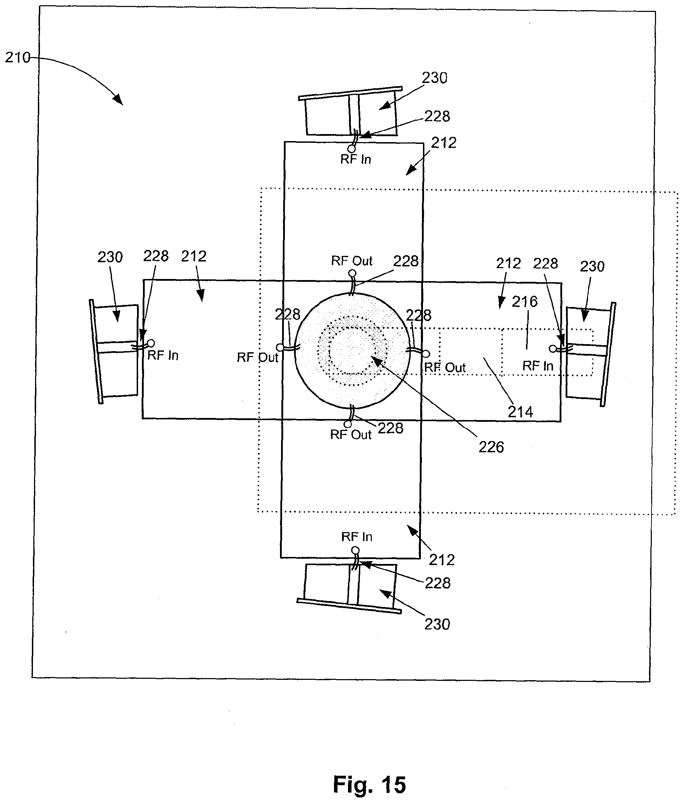

Circuits 212 are connected to interface 214 or another structure such as a pin 226 (described below) with a wirebond 228. Wirebond 228 further connects circuits 212 to various other structures. For example, in one example depicted in FIGS. 11 and 15, wirebond 228 connects circuits 212 to an input device such as a microstrip 230. In other examples, wirebond 228 connects circuits 212 to various other input structures such as another interface 214 as disclosed in co-pending application entitled "Adjustable Low-Loss Interface" noted above.

Wirebond 228 may comprise an electrically conductive low-loss material and wirebond 228 may further comprise leads, pins, ribbons or anything else that connects two or more devices that transmit energy. Certain exemplary wirebond materials include, but are not limited to, gold, silver, copper, various alloys, beryllium, copper, tungsten, and/or other similar materials with high conductivity and low resistance.

Furthermore, any device or piece of material configured to transport energy can be used as wirebond 228. Certain exemplary wirebonds 228 are 0.15 millimeters to 25 millimeters in length. Wirebond 228 can be any size suitable for the particular location that system 210 is used for. For example, if a long distance is required between circuits 212 and interface 214, wirebond 228 can be longer to accommodate that distance. Further, in certain other examples, wirebond 228 can be a probe, a coaxial pin, cable or another type of device with a coaxial configuration. In other examples wirebond 228 is a spongy material such as disclosed in the co-pending patent application noted above entitled Low-Loss Interface.

Interface 214 is configured to connect any energy transmission, reception, or similar device to energy transmission device 216 or any other device configured to transport energy. While not mandatory, interface 214 can be used within system 210 to reduce loss as explained herein. In one exemplary embodiment, interface 214 is a step launch. The step launch may comprise a stepped transition defining an interface cavity that increases in volume up to the volume of a waveguide cavity. The stepped transition defines a series of ridges or steps 232 along an interface cavity which leads into the waveguide cavity. In one example the step launch is configured such that steps 232 are larger in the direction from the interface cavity to the waveguide cavity. In another example the depth and/or height of each step may be the same from step to step so that each step may resemble the step before it. In one example the height of each step is 0.5 millimeters at Ka band frequencies. At lower frequencies, the height can more significant; for example, a height of 3 millimeters. In other examples however, the depth and/or height of each step may vary compared to one or more other steps in the step launch. Moreover, the corner or edges of steps 232 are rounded to approximately a radius of 0.001 millimeters to 1 millimeter in one exemplary embodiment which further reduces loss.

The step launch or other interface 214 can be constructed from any conductive material that minimizes loss. In an exemplary embodiment, interface 214 is gold plated. In other examples interface 214 is comprised of silver, copper, aluminum, plated plastics, plated ceramics, various metals and/or alloys, and/or other similar materials with low resistance. Any materials configured to facilitate impedance matching and reduce signal loss can be used to construct interface 214.

The step launch is configured to provide a stepped transition from the impedance of circuits 212 to the impedance of energy transmission device 216. The number of steps 232 is typically related to the size of the cavity defined by energy transmission device 216 in that the larger cavity, the greater number of steps 232 may be used to match the output impedance of circuits 212 to the energy transmission device 216 such as waveguide. It should also be noted that the steps' length and height can be selected to reduce loss depending on the application that interface 214 is used for. For example, the second ridge or step of the step launch can be built to be longer than the first ridge as shown. In this embodiment, the insertion loss has been shown to be less than 0.2 dB from 27 GHz to 38.6 GHz. In other embodiments, adjusting the various dimensions of the ridges or steps has reduced insertion loss to less than 0.1 dB based on an energy frequency increase from 27 GHz to 38.4 GHz.

The number of steps may be a function of room available for transition and manufacturability of steps. Specifically, a smaller cavity may have less step features than a larger cavity. According to an example of the present invention, any number of ridges, steps, or other similar features can be used and fall within the scope of the present invention. In certain exemplary embodiments, the size of the steps is a function of frequency. Therefore, the steps may be smaller at higher frequencies and larger at lower frequencies. In yet other examples interface 214 can comprise a smooth, slopped transition without steps. The angle of the transition can be whatever angle needed to accommodate energy transmission device 216. Certain exemplary stepped transitions for various step launches include, but are not limited to, triangular, exponential, or Klopfenstein tapers.

System 210 further comprises energy transmission device 216. In one exemplary embodiment, energy transmission device 216 is a waveguide that transports microwave energy waves. Certain exemplary examples of waveguides may be circular waveguides, rectangular waveguides, and parallel plate waveguides. However, in other examples energy transmission device 216 can be any type of device or medium configured to transport energy such as feed horns, antennas, or other devices configured to transport and guide energy waves from one source to another. In yet another example, energy transmission device 216 comprises other integrated circuits such as a MMIC or anything else that transport electrical energy.

With reference again to FIG. 11 and according to one example of the present invention, system 210 may further comprise an isolation wall 234 as described in the application noted above entitled "Adjustable Low-Loss Interface." Isolation wall 234 is located between the input and output regions of one or more of circuits 212. Isolation wall 234 is any structure that separates the input and output region and is configured to reduce ripple and other interference between the input and output regions to reduce loss. An exemplary isolation wall 234 comprises metal structures, microwave absorbers, and dielectrics that reduce ripple. Reducing the ripple at this location also reduces the overall loss of power in the energy waves at the transition between circuits 212 and energy transmission device 216.

Further, isolation wall 234 isolates the input and output pads (i.e. the input and output regions) present on circuits 212 such as a MMIC. Isolating the input and output regions of a MMIC reduces the chances that oscillation will occur at the MMIC or other circuits 212.

Maintaining this isolation is important because numerous undesirable effects arise when the proper isolation is not present. For example, the oscillation experienced by certain circuits such as a MMIC is problematic. Further, the interactions between the input and output regions leads to excess ripple which in turn reduces performance leads to less output power and more gain variation. These problems are all magnified when working with energy at higher frequencies. Therefore, isolation wall 234 prevents loss at high frequencies and increases performance.

Isolation wall 234 can be constructed from the same material as structure 218 such as aluminum or copper or it can be constructed of another material and, for example, plated with silver or gold. In this example isolation wall 234 is approximately one millimeter thick. In other examples isolation wall 234 is approximately 0.25 to fifty millimeters thick. Isolation wall 234 is also approximately 1 millimeter to 50 millimeters wide. In one example isolation wall 234 is 5 millimeters wide at Ka band. Any size or shape of isolation wall 234 that is configured to reduce ripple by isolating input region from the output region falls within the scope of the present invention. Further, isolation wall 234 can be a simple vertical member depicted in FIG. 11 or it can have a flange or other similar horizontal member.

In certain exaamples isolation wall 234 is placed at a distance of approximately .5 to .05 millimeters away from one or more of circuits 212. In other exemplary embodiments, isolation wall is placed at a distance in the range of .25 millimeters away from circuits 212 or anywhere in a range of approximately .25 to .5 millimeters away from circuits 212. In yet other examples other distance ranges can be used and fall within the scope of the present invention. Further, in an example when MMICs are used as integrated circuits 212, isolation wall 234 is placed immediately after the last gain stages on the MMICs and the output wirebond. However, isolation wall 234 can be placed at any location along in system 210 and fall within the scope of the present invention.

System 210 enables numerous circuits 212 to be combined into a single system 210. There are various different configurations and methods of combining circuits 212 and a few, non-limiting examples will be discussed herein. For example, as depicted in the example shown in FIG. 11, two circuits 212 are used in system 210. In this embodiment, one circuit 212 is disposed on lid 220 and another circuit 212 is disposed on base 222. Each circuit is connected by wirebond 228 to an input source such as a microstrip (not shown) on circuits 212 and connected by another wirebond 228 to interface 214. An isolation wall 234 is attached to a lateral side of structure 218.

In certain examples energy from each circuit 212 combines spatially and it is in phase as it transitions from circuit 212 to energy transmission device 216. In one example a phase match of twenty degrees or less is desired to keep phase balance losses below a tenth of a decibel.

As depicted in Fig. 11, interfaces 214 are symmetric on the lid 220 and base 222 as would occur when circuits 212 are the same device. For example, each circuit 212 could be a 4 watt high power amplifier. Each high watt power amplifier contributes half of the energy outputted at energy transmission device 216. Therefore, 8 watts of energy would be outputted. In other examples lid 220 and base 222 are not symmetric and contain different circuits 212. For example, lid 220 might have a 2 watt high power amplifier and base 22 might have a 4 watt high power amplifier. In yet another example a 2 watt circuit 212 may be present on lid 220 while the circuit 212 on base 222 is a power detector, or another electrical device.

In another example not shown, two additional circuits 212 could be used in a system as depicted in FIG. 11. If four circuits 212 are used, two additional circuits 212 are placed on the right and left lateral side of structure 218 beneath circuit 212 located on lid 220.

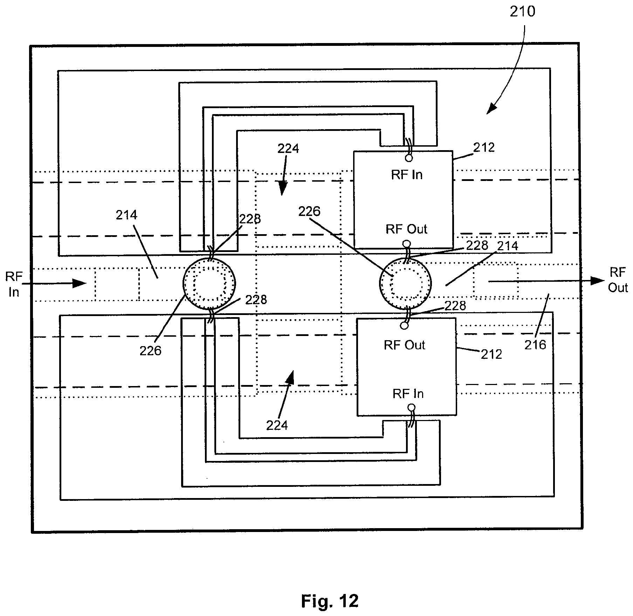

With reference now to FIGS. 12 and 13 and in accordance with another example two circuits 212 can be connected to pin 226 by wirebond 228. Pin 226 in turn is then connected to interface 214. Pin 226 is any device configured to transport electrical energy from circuits 212 to another destination such as interface 214. In one exemplary embodiment, pin 226 has a coaxial structure with a center conductor and an outer conductor. Pin 226 can be constructed from any electrically conductive material. In certain exemplary embodiments, pin 226 is constructed from the same material as interface 214 and is gold plated. In other examples pin 226 is comprised of silver, copper, aluminum, plated plastics, plated ceramics, various metals and/or alloys, and/or other similar materials with low resistance.

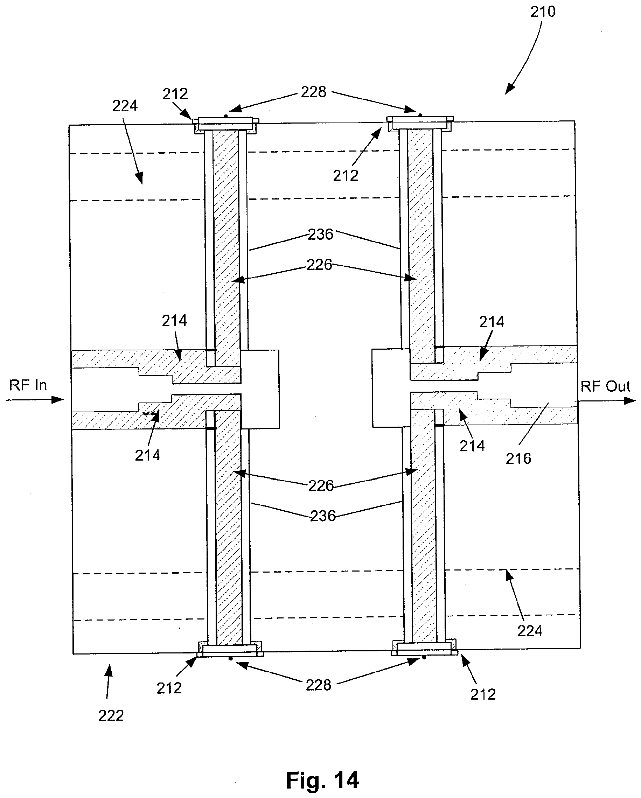

With particular reference to FIGS. 13 and 14 and according to one example of the present invention, pin 226 is seated or disposed within structure 218 and surrounded by an air channel 236. In other exemplary embodiments, air is not used in air channel 236 and another dielectric is used. Certain exemplary dielectrics comprise glass, quartz, foam, or a product such as Teflon® produced by the E. I. DuPont DeNemours and Company of Wilmington, Delaware or other to increase mechanical stability. In one example pin 226 further comprises a flange member (not shown) to secure it to lid 220 or base 222. As shown in FIG. 13, one pin 226 is connected to interface 214 that serves as in input region for energy such as RF energy while another pin 226 is connected to another interface 214 that serves an output region for RF energy. In this example two circuits 212 are each connected to a pin 226 that is in contact with the output region. As shown, pin 226 is disposed only on lid 220.

In other examples additional pins 226 and associated circuits 212 can be used. For example, pins 226 can be inserted into base 222 and additional circuits 212 can be added to further increase the power provided by system 210. One such exemplary system is shown in FIG. 14 which depicts a similar system 210 as shown in FIG. 13 except this system 210 includes four circuits 212 with two circuits 212 on lid 220 and two circuits on base 222. In various examples circuits 212 are wire bonded to pin 226.

In yet another example four or even eight circuits can be added to system 210 and various of the power combining devices disclosed herein can be used together to comprise system 210. With particular reference to FIG. 15, four circuits are placed on the either lid 220 or base 222 and connected to pin 226 by wirebond 228.

In another example where eight circuits 212 are required, four additional circuits 212 could be placed on base 222. Thus, in accordance with various examples radial combining of circuits 212 is facilitated by connecting multiple circuits 212 to pin 226. In yet other embodiments were six or seven circuits 212 are power combined by varying the number of circuits 212 placed on lid 220 and base 222 to reach the desired amount. In various example the larger the circuits 212 that are used, the larger pin 226 is for the instances when there are more than two circuits 212. Alternatively, the size of pin 226 my increase depending on the number of circuits 212 connected to a particular pin (i.e. a larger pin 226 is utilized with six circuits than is utilized with four circuits). In certain examples circuits 212 are located close pin 226. Typically the higher the frequency, the smaller the distance between circuit 212 and pin 226.

In certain examples with numerous circuits 212, it may be beneficial to provide electrical isolation between circuits 212. One such example is when system 210 is utilized with a high power amplifier. If electrical isolation between various circuits 212 is not provided, certain systems 210 (such as a power amplifier) can have unacceptable amounts of loss and ripple. In one example electrical isolation between circuits 212 can be provided by utilizing a coupler that can provide isolation between two ports.

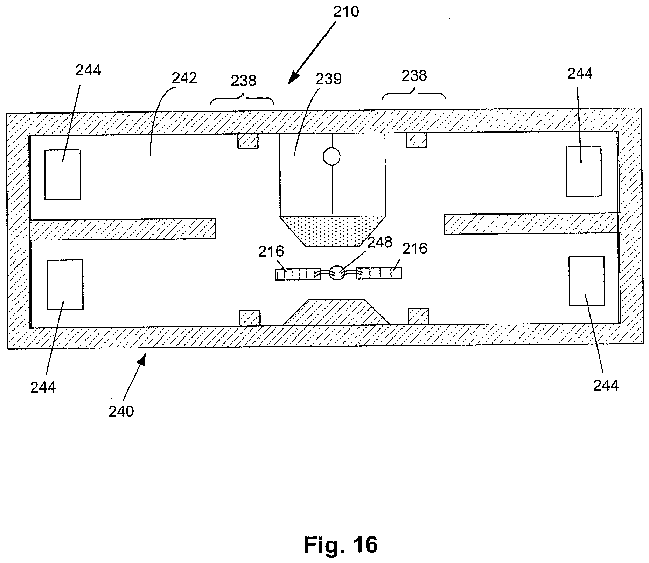

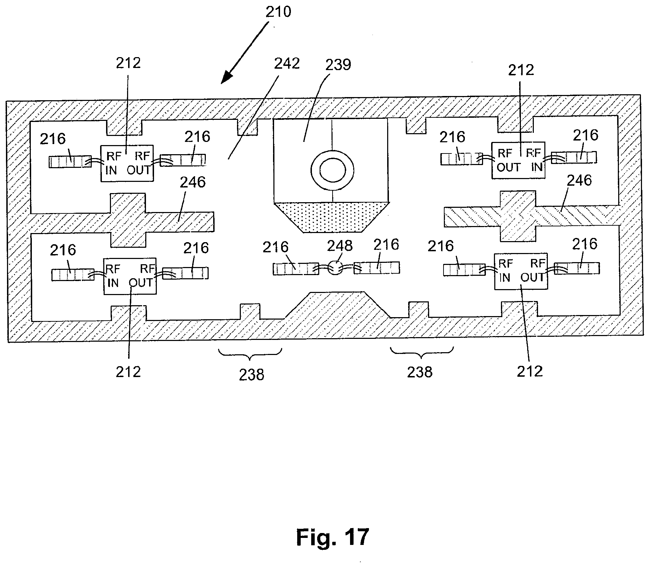

With particular reference to FIGS. 16 and 17 and according to one example system 210 utilizes multiple 90 degree hybrid couplers 238 to separate the various circuits 212. Specifically, FIGS. 16 and 17 depict sections of a multi-leveled electronic system such as a power amplifier that would be stacked on top of another. Energy amplified and/or combined at one section of a multi-level electronic system travels to another section where it is amplified and/or combined and/or split.

One exemplary coupler 238 is a three decibel coupler. In this example the isolated port is terminated with RF load 239. The section of coupler 238 depicted in FIG. 16 in this example comprises a body 240 that defines one or more openings 244 that allow a user to see within the splitting level depicted in FIG. 17. The multi-level electronic system further defines a waveguide cavity 242 that guides energy to energy transmission device 216 and an associated pin 248 where it is delivered to or received from another section such as that depicted in FIG. 17.

With reference to FIG. 17 and according to one example of the present invention, this section of the multi-level electronic system comprises one or more walls 246 and houses four circuits 212. Energy from the splitting level referenced in FIG. 16 is inputted into circuits 212 and amplified. Energy enters and exits circuits 212 through energy transmission devices 216 as shown. After amplification, the energy travels along a waveguide cavity 242 defined by the multi-level electronic system. Energy leaves coupler 238 through energy transmission devices 216 that are wire boned to pin 248 where it is delivered to another section of the multi-level electronic system, such as the section shown in FIG. 16.

Coupler 238 can be any known device capable of electrically isolating power from two or more circuits 212. Certain exemplary couplers 238 comprise a three decibel split block 90 degree hybrid coupler, Lange coupler or magic tee, or a Wilkinson power divider.

In accordance with various examples of the present invention, system 210 is configured to reduce or eliminate the use of power combiners as compared to a system that does not perform power combining by attaching multiple MMICs directly to a wave-guide step launch. In addition, FIGS. 12 through 15 can be constructed in multi-levels to facilitate assembly and manufacturing.

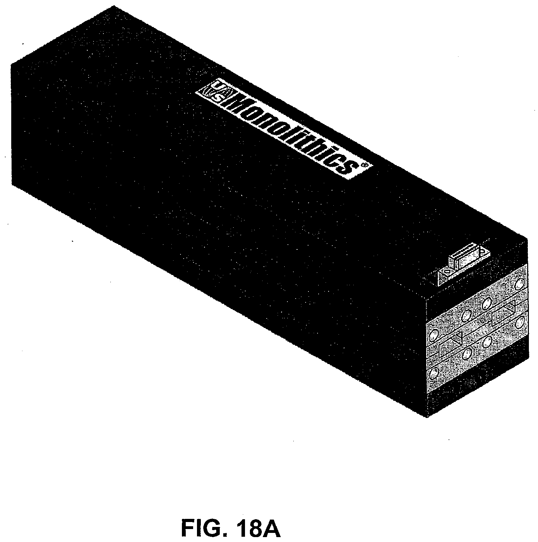

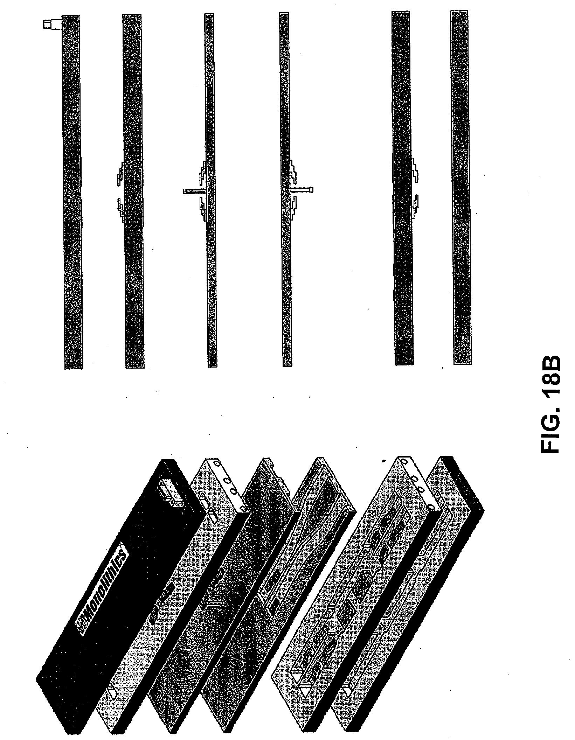

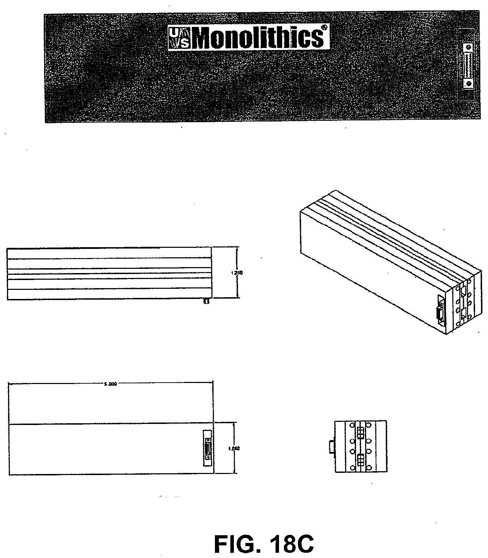

FIGS. 18A-18C show one system comprising system 210 according to one example of the present invention. The various energy transmission devices, circuits, pins, and other components are shown in the various other figures depicting this example of the present invention.

## Claims

1. A system comprising:
a monolithic microwave integrated circuit (11, 111, 212) comprising an input pad, and an output pad, the monolithic microwave integrated circuit (11, 111, 212) having a first impedance;
a waveguide (120) having a second impedance;
an interface (10, 110); and
a structure (17) surrounding the monolithic microwave integrated circuit (11, 111,
212) and the interface,
wherein the interface comprises:
a waveguide step launch (16, 115) having the first impedance at the first end and the second impedance at a second end, wherein the second end is connected to the waveguide (120);
a first isolation wall (122) placed above the monolithic microwave integrated circuit and located between the input pad and the output pad, the first isolation wall being part of the structure (17) surrounding the monolithic microwave integrated circuit (11, 111, 212) and the interface; and
a cavity (118) defined by the waveguide step launch (16, 115), wherein the cavity has a different size at different points along the direction of a microwave pathway, and wherein the size of the cavity increases at different points along the direction of the microwave pathway from the monolithic microwave integrated circuit (11, 111, 212) to the waveguide (26, 120),
wherein the output pad (116) of the monolithic microwave integrated circuit (11, 111, 212) is connected by a wirebond (112) to either the isolation wall (122) or to the waveguide step launch (16, 115).

2. The system of claim 1, wherein the interface (10, 110) further comprises a pin that connects the waveguide step launch (16, 115) to the monolithic microwave integrated circuit (11, 111, 212).

3. The system of claim 1, wherein the waveguide step launch (16, 115) comprises a stepped transition.

4. The system of claim 1, wherein the waveguide step launch (16, 115) comprises a sloped transition.

5. The system of claim 1, wherein the interface comprises an adjustable member configured to adjust the volume of the portion of cavity (119) defined by the interface.

6. The system of claim 5, wherein the adjustable member is a turning screw (138) in communication with the cavity that adjusts the volume of the cavity along the portion of the cavity defined by the interface (110).

7. The system of claim 6, wherein the turning screw (138) is located on an opposing side of the cavity from the interface (110).

8. The system of claim 1, wherein the first isolation wall is approximately 0.5 to 0.05 millimeters from the monolithic microwave integrated circuit (111).

## Patentansprüche

1. System, umfassend:
eine monolithische integrierte Mikrowellenschaltung (11, 111, 212), die eine Eingangskontaktstelle und eine Ausgangskontaktstelle umfasst, wobei die monolithische integrierte Mikrowellenschaltung (11, 111, 212) eine erste Impedanz aufweist;
einen Wellenleiter (120), der eine zweite Impedanz aufweist;
eine Schnittstelle (10, 110); und
eine Struktur (17), die die monolithische integrierte Mikrowellenschaltung (11, 111, 212) und die Schnittstelle umgibt,
wobei die Schnittstelle umfasst:
einen Wellenleiter-Stufenwandler (16, 115) mit der ersten Impedanz am ersten Ende und der zweiten Impedanz an einem zweiten Ende, wobei das zweite Ende mit dem Wellenleiter (120) verbunden ist;
eine erste Isolationswand (122), die über der monolithischen integrierten Mikrowellenschaltung und zwischen der Eingangskontaktstelle und der Ausgangskontaktstelle angeordnet ist, wobei die erste Isolationswand Teil der Struktur (17) ist, die die monolithische integrierte Mikrowellenschaltung (11, 111, 212) und die Schnittstelle umgibt; und
einen Hohlraum (118), der durch den Wellenleiter-Stufenwandler (16, 115) definiert ist, wobei der Hohlraum an verschiedenen Punkten entlang der Richtung eines Mikrowellenweges eine unterschiedliche Größe aufweist, und wobei die Größe des Hohlraumes an verschiedenen Punkten entlang der Richtung des Mikrowellenweges von der monolithischen integrierten Mikrowellenschaltung (11, 111, 212) zum Wellenleiter (26, 120) zunimmt,
wobei die Ausgangskontaktstelle (116) der monolithischen integrierten Mikrowellenschaltung (11, 111, 212) mittels einer Drahtbondverbindung (112) mit der Isolationswand (122) oder mit dem Wellenleiter-Stufenwandler (16, 115) verbunden ist.

2. System nach Anspruch 1, wobei die Schnittstelle (10, 110) ferner einen Stift umfasst, der den Wellenleiter-Stufenwandler (16, 115) mit der monolithischen integrierten Mikrowellenschaltung (11, 111, 212) verbindet.

3. System nach Anspruch 1, wobei der Wellenleiter-Stufenwandler (16, 115) einen stufenförmigen Übergang umfasst.

4. System nach Anspruch 1, wobei der Wellenleiter-Stufenwandler (16, 115) einen abgeschrägten Übergang umfasst.

5. System nach Anspruch 1, wobei die Schnittstelle ein einstellbares Element umfasst, das ausgebildet ist, um das Volumen des durch die Schnittstelle definierten Abschnittes des Hohlraums (119) einzustellen.

6. System nach Anspruch 5, wobei das einstellbare Element eine Drehschraube (138) ist, die mit dem Hohlraum in Verbindung steht und das Volumen des Hohlraums entlang des durch die Schnittstelle (110) definierten Abschnittes des Hohlraums einstellt.

7. System nach Anspruch 6, wobei die Drehschraube (138) auf einer der Schnittstelle (110) gegenüberliegenden Seite des Hohlraumes angeordnet ist.

8. System nach Anspruch 1, wobei die erste Isolationswand ungefähr 0,5 bis 0,05 Millimeter von der monolithischen integrierten Mikrowellenschaltung (111) entfernt ist.

## Revendications

1. Système comprenant :
un circuit intégré monolithique hyperfréquences (11, 111, 212) comprenant un plot d'entrée, et un plot de sortie, le circuit intégré monolithique hyperfréquences (11, 111, 212) ayant une première impédance ;
un guide d'onde (120) ayant une seconde impédance ;
une interface (10, 110) ; et
une structure (17) entourant le circuit intégré monolithique hyperfréquences (11, 111, 212) et l'interface,
dans lequel l'interface comprend :
un support de guide d'onde (16, 115) ayant la première impédance à la première extrémité et la seconde impédance à une seconde extrémité, dans lequel la seconde extrémité est reliée au guide d'onde (120) ;
une première paroi d'isolation (122) placée au-dessus du circuit intégré monolithique hyperfréquences et située entre le plot d'entrée et le plot de sortie, la première paroi d'isolation faisant partie de la structure (17) entourant le circuit intégré monolithique hyperfréquences (11, 111, 212) et l'interface ; et
une cavité (118) définie par le support de guide d'onde (16, 115), dans lequel la cavité a une taille différente en différents points dans la direction d'un trajet de micro-ondes, et dans lequel la taille de la cavité augmente en différents points le long de la direction du trajet de micro-ondes du circuit intégré monolithique hyperfréquences (11, 111, 212) au guide d'onde (26, 120),
dans lequel le plot de sortie (116) du circuit intégré monolithique hyperfréquences (11, 111, 212) est relié par un fil (112) soit à la paroi d'isolation (122) soit au support de guide d'onde (16, 115).

2. Système selon la revendication 1, dans lequel l'interface (10, 110) comprend en outre une broche qui relie le support de guide d'onde (16, 115) au circuit intégré monolithique hyperfréquences (11, 111, 212).

3. Système selon la revendication 1, dans lequel le support de guide d'onde (16, 115) comprend une transition progressive.

4. Système selon la revendication 1, dans lequel le support de guide d'onde (16, 115) comprend une transition inclinée.

5. Système selon la revendication 1, dans lequel l'interface comprend un élément réglable configuré pour ajuster le volume de la partie de la cavité (119) définie par l'interface.

6. Système selon la revendication 5, dans lequel l'élément réglable est une vis (138) en communication avec la cavité qui ajuste le volume de la cavité le long de la partie de la cavité définie par l'interface (110).

7. Système selon la revendication 6, dans lequel la vis (138) est située sur un côté opposé de la cavité par rapport à l'interface (110).

8. Système selon la revendication 1, dans lequel la première paroi d'isolation se trouve à environ 0,5 à 0,05 millimètre du circuit intégré monolithique hyperfréquence (111) .
